# EUROPÄISCHE PATENTANMELDUNG

(11) **EP 2 437 240 A1**
(43) Veröffentlichungstag der Anmeldung: **04.04.2012**
(21) Anmeldenummer: 10183985.0
(22) Anmeldetag: 30.09.2010
(51) Int. Cl.: G09F 9/305, B23K 26/00

(54) **Formteil aus einem transparenten Material und Verfahren zur Herstellung**

(71) Anmelder: SIEMENS AKTIENGESELLSCHAFT, 80333 München (DE)
(72) Erfinder: Bräunlich, Michael, 09117, Chemnitz (DE); Chowaniec, Michael, 09113, Chemnitz (DE); Ebel, Meik, 92272, Lintach (DE); Kestel, Oliver, 92245, Kümmersbruck (DE)

(57) **Zusammenfassung**

Die Erfindung betrifft ein Formteil (2), umfassend
- ein transparentes Material,
- eine Deckschicht (4),
**dadurch gekennzeichnet**, dass zwischen der Deckschicht (4) und dem transparenten Material eine
- Grundschicht (5) mit einer
i. ersten Oberfläche (5a) und
ii. einer zweiten Oberfläche (5b) derart angeordnet ist,

dass die erste Oberfläche (5a) zu der Deckschicht (4) gerichtet ist und die zweite Oberfläche (5b) zu dem transparenten Material gerichtet ist, wobei die Grundschicht (5) geeignet ist einen in das transparente Material eingeleiteten Lichtstrahl bis an die erste Oberfläche (5a) der Grundschicht (5) zu führen.

## Beschreibung

Die Erfindung betrifft ein Formteil, umfassend ein transparentes Material und eine Deckschicht. Derartige Formteile sind nach dem allgemein bekannten Stand der Technik weitläufig bekannt. Beispielsweise werden für den Gehäusebau für elektronische Geräte Kunststoffformteile verwendet. In der Automatisierungstechnik, aber auch in anderen Bereichen, werden elektronische Geräte mit einer zunehmenden Leistungsdichte und Flexibilität entwickelt. Daraus ergibt sich zwangsläufig eine erhöhte Anforderung an eine Mensch/Maschine-Schnittstelle, welche insbesondere auf eine leichte intuitive Ablesbarkeit und Bedienbarkeit des Gerätes ausgerichtet ist. Insbesondere wird eine visuelle Kommunikation in Form von Lichtleitern benötigt. Das Licht wird anhand einer LED auf einer Leiterplatte eingespeist und bis zu einer Frontseite eines elektrisch bedienbaren Gerätes geleitet. Je nach Gerätetyp muss auch eine Beschriftung auf der Frontseite immer höheren Anforderungen genügen.

Eine bisher verwendete Lösung führt zu einer zu hohen Teilevielfalt und zu komplizierten Geometrien von beispielsweise Gehäuseabdeckungen. Eine Frontblende, beispielsweise einer in der Automatisierungstechnik gebräuchlichen Ein-/Ausgabebaugruppe, ist mit unterschiedlichen Lichtleitern, für beispielsweise 2-,4- oder 8-Kanal-Baugruppen, ausgestattet. Für die Anzeige der einzelnen Kanäle sind in der Frontblende Durchbrüche eingearbeitet. Diese Durchbrüche werden vor der Montage der Baugruppe in der laufenden Produktion, beispielsweise in die Fronthaube eingestanzt. Danach werden passende Lichtleiter für diese Durchbrüche montiert.

Des Weiteren betrifft die Erfindung auch ein Verfahren zur Herstellung von Formteilen, insbesondere zur Herstellung von Geräteabdeckungen.

Es ist Aufgabe der Erfindung ein Formteil bzw. ein Verfahren für ein Formteil bereitzustellen, welche die Produktionsabläufe beim Herstellen, beispielsweise von elektronischen Baugruppen, vereinfacht.

Die Aufgabe wird durch ein Formteil, umfassend ein transparentes Material und eine Deckschicht, dadurch gelöst, dass zwischen der Deckschicht und dem transparenten Material eine Grundschicht mit einer ersten Oberfläche und einer zweiten Oberfläche derart angeordnet ist, dass die erste Oberfläche zu der Deckschicht gerichtet ist und die zweite Oberfläche zu dem transparenten Material gerichtet ist, wobei die Grundschicht geeignet ist einen in das transparente Material eingeleiteten Lichtstrahl bis an die erste Oberfläche der Grundschicht zu führen. Auf das Formteil aus dem transparenten Material wird nun vorzugsweise eine 2-Schicht-Lackierung aufgebracht. Dabei besteht die 2-Schicht-Lackierung aus einer Deckschicht, welche im Wesentlichen lichtundurchlässig ist und aus einer Grundschicht, welche im Wesentlichen lichtdurchlässig ist. Aus diesem Formteil, welches noch einem Rohteil entspricht, kann später mit Vorteil jede beliebige Ausgestaltung einer elektronischen Baugruppe hergestellt werden.

Vorzugsweise wird dabei das Formteil als eine Geräteabdeckungen ausgestaltet.

In einer weiteren Ausgestaltung des Formteils kann die Grundschicht als eine Lackschicht oder eine Folie ausgestaltet sein.

Im Hinblick auf eine weitere Optimierung eines Produktionsprozesses von elektronischen Baugruppen, insbesondere Geräteabdeckungen, ist es von Vorteil, wenn das Formteil im Wesentlichen gänzlich aus dem transparenten Material gefertigt ist. Das bedeutet, dass ein transparentes Materialstück, beispielsweise bereits als ein Baugruppendeckel vorliegt, welches mit der 2-Schicht-Lackierung behandelt ist.

Da bereits bei der Formung des Formteiles, beispielsweise mit einer Spritzgusstechnik, das Formteil derart ausgeformt ist, dass es Anformungen oder Stege aufweist, welche später als Lichtleiter ausgestaltet sind, wird ein Fertigungsverfahren für elektronische Baugruppen vereinfacht. Denn nach dem Stand der Technik mussten zuvor Ausnehmungen in den Formteilen, vorzugsweise ein Gehäusedeckel, an den entsprechenden Stellen für die Lichtleiter ausgestanzt werden und die Lichtleiter wurden sodann in diese ausgestanzten Durchbrüche montiert.

Für eine spätere Mensch/Maschine-Schnittstelle ist das Formteil derart ausgestaltet, dass die Deckschicht Ausnehmungen aufweist, welche Anzeigebereiche und/oder Schriftzeichen bilden, wobei die Ausnehmungen die erste Oberfläche der Grundschicht derart stellenweise freilegen, dass der eingeleitete Lichtstrahl an der ersten Oberfläche austreten kann.

Diese Ausnehmungen werden vorzugsweise durch eine Behandlung der Deckschicht mit einer Laser- oder thermisch durchgeführten Schreibtechnik erreicht. Die Deckschicht besteht dabei aus einer Laser- und thermisch beschreibbaren Oberfläche. Dabei ist die Deckschicht ein weitestgehend lichtundurchlässiges Material und die Grundschicht ein weitestgehend lichtdurchlässiges, insbesondere transluzentes, Material.

Im Fall einer Gehäuseabdeckung, beispielsweise einer Fronthaube einer Automatisierungsbaugruppe, kann ein Fertigungsverfahren derartiger Fronthauben dadurch vereinfacht werden, dass die Fronthaube aus einem transparenten Material gefertigt ist, bei welchen bereits alle denkbaren Lichtleiter eingeformt sind. Die Frontseite wird zunächst mit einem teiltransparenten (transluzenten) Grundlack lackiert, auf diesen Grundlack wird später ein undurchsichtiger dunkler Decklack aufgetragen und bildet die Deckschicht. Im weiteren Fertigungsschritt für derartige Gehäuseabdeckungen kann nun je nach Einsatzzweck der Gehäuseabdeckung der Decklack mit einem Laser entfernt werden. Durch die Entfernung des Decklackes wird die Grundschicht freigelegt. Die Grundschicht, also die Grundlackschicht, erfüllt zwei Funktionen. Zum Einen lässt sie das Licht, das durch die Lichtleiter von LEDs herangeführt wird, passieren. Zum Anderen kann eine Beschriftung durch den gleichen Laserprozess erzeugt werden. Die Grundschicht, also der Grundlack, ist vorzugsweise so pigmentiert, dass dieser einen ausreichenden Kontrast zum Decklack bildet und dabei eine Lichtleitfunktion möglichst nicht beeinträchtigt.

Demnach wird in einem Verfahren zum Herstellen von Formteilen, wobei diese aus einem transparenten Material geformt werden, auf das transparente Material eine Grundschicht mit einer ersten Oberfläche und einer zweiten Oberfläche derart aufgetragen, dass die zweite Oberfläche zu dem transparenten Material gerichtet ist, wobei für die Grundschicht ein Material verwendet wird, welches geeignet ist, einen in das transparente Material eingeleiteten Lichtstrahl bis an die erste Oberfläche der Grundschicht zu führen, anschließend wird sodann auf die Grundschicht eine Deckschicht aufgetragen.

Die Zeichnung zeigt in den Figuren ein Ausführungsbeispiel.
- FIG 1: zeigt eine Geräteabdeckung 1 und
- FIG 2: zeigt eine Schnittdarstellung der Geräteabdeckung 1.

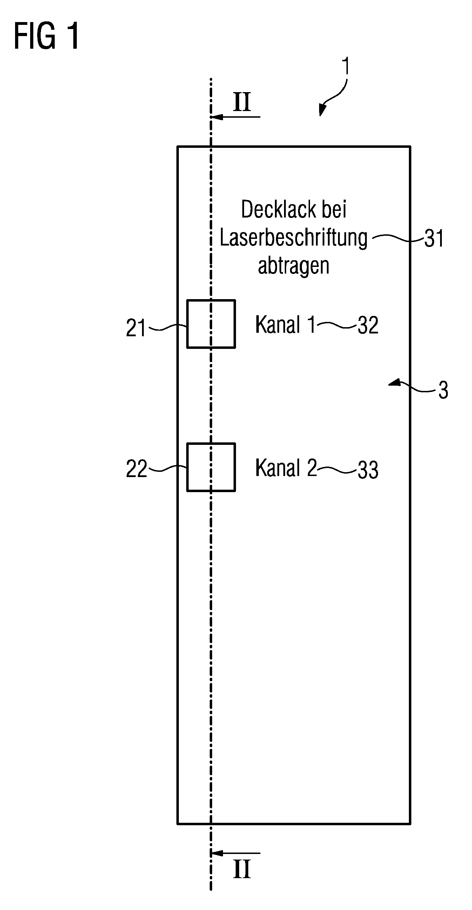

Gemäß FIG 1 ist eine Geräteabdeckung 1 in einer Frontansicht dargestellt. Die Geräteabdeckung 1 weist eine Betrachtungsfläche 3 auf, welche ein erstes Schriftfeld 31 "Decklack bei Laserbeschriftung abgetragen", ein zweites Schriftfeld 32 "Kanal 1" und ein drittes Schriftfeld 33 "Kanal 2" aufweist. Jeweils links neben dem zweiten und dritten Schriftfeld 32,33 befindet sich eine erste Öffnung 21 und eine zweite Öffnung 22 für je eine visuelle Anzeige.

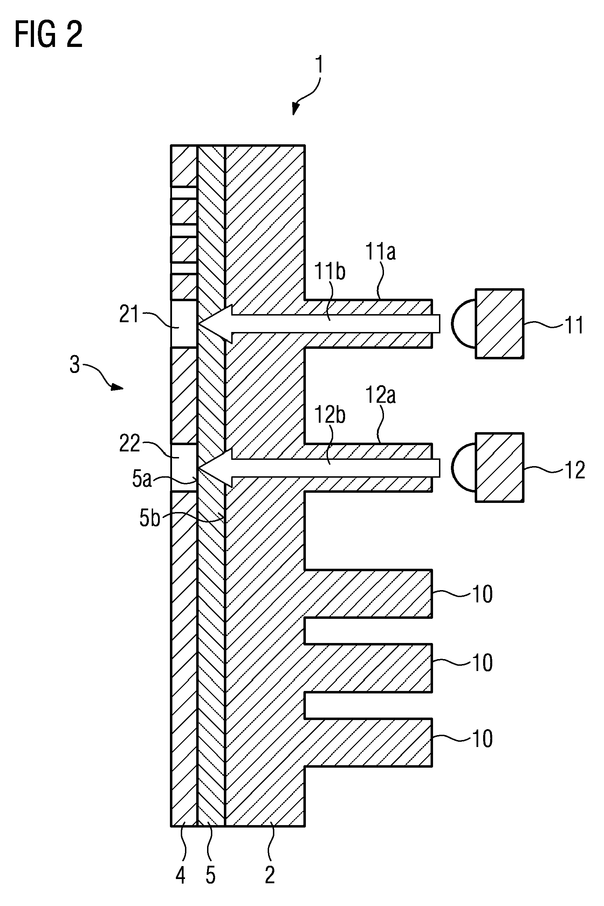

Gemäß FIG 2 ist die Geräteabdeckung 1 aus FIG 1 in einer Schnittdarstellung der Schnittlinie II aus FIG 1 dargestellt. Von links nach rechts gesehen weist die Geräteabdeckung 1 zunächst die Betrachtungsfläche 3 auf. Die Betrachtungsfläche 3 wird dabei im Wesentlichen aus einer Deckschicht 4 gebildet. Nach der Deckschicht 4 folgt eine Grundschicht 5. Die Grundschicht 5 ist auf das Formteil 2 aufgebracht. Dieses Formteil 2 besteht im Wesentlichen aus einem transparenten, also lichtdurchlässigen Material. Die erste Öffnung 21 und die zweite Öffnungen 22 dienen jeweils der visuellen Anzeige von Licht und sind als Ausnehmungen in der Deckschicht 4 ausgestaltet. Diese Ausnehmungen werden derart in die Deckschicht eingebracht, dass eine erste Oberfläche 5a der Grundschicht 5 derart stellenweise freigelegt wird, dass ein in das transparente Material eingeleiteter Lichtstrahl an der ersten Oberfläche 5a austreten kann.

Das Formteil 2 weist einen ersten Lichtleiter 11a und einen zweiten Lichtleiter 12a auf. Diese Lichtleiter 11a,12a sind als Stege senkrecht zu der Betrachtungsfläche 3 auf dem Formteil angeordnet. Eine erste LED 11 und eine zweite LED 12 sind derart hinter den Lichtleitern 11a,12a angeordnet, dass diese LEDs 11,12 Licht in die Lichtleiter 11a,12a einspeisen. Durch die erste LED 11 wird ein erster Lichtstrahl 11b und durch die zweite LED 12 ein zweiter Lichtstrahl 12b erzeugt. Diese Lichtstrahlen 11b,12b werden, von rechts nach links betrachtet, nun durch den jeweiligen Lichtleiter 11a,12a durch das Formteil 2 bis an die zweite Oberfläche 5b geführt und dadurch, dass die Grundschicht 5 aus einem transparenten Material besteht, auch weiter bis an die erste Oberfläche 5a geführt. An Stellen, an denen die Deckschicht 4 noch intakt ist, kann das durch die Lichtleiter 11a,12a geführte Licht nicht austreten. Weitere Lichtleiterstege 10 stehen für Baugruppen mit einer erweiterten Anzeigefunktionalität zur Verfügung, diese müssten dann in dem Laserprozess durch Abtragen der Deckschicht 4 entsprechend freigelegt werden. Aber an den Stellen, an denen Ausnehmungen platziert sind, kann das Licht austreten und wird somit auf der Betrachtungsfläche 3 als visuelles Signal sichtbar.

Als Vorteil wird auch angesehen, dass ein Laserprozess zur Bildung der Ausnehmungen oder der Schriftzeichen eine individuelle Gestaltung des Bauteils in der laufenden Fertigung ermöglicht. Beispielsweise ist es damit möglich, eine Fronthaube mit Lichtleitern für eine ganze Bandbreite von Modulen zu erzeugen und erst in der Fertigungslinie festzulegen, welcher Lichtleiter freigelasert werden soll. Es muss nur ein universelles Formteil auf Lager gehalten werden und die Fertigung eines individuellen Teils erfordert nur einen Montageschritt. Weiterhin wird als Vorteil angesehen, dass eine Teilelogistik auf ein Teil reduziert werden kann.

Bei einem Freilegen der Ausnehmungen oder Schriftzeichen mittels eines Lasers ist die Laserenergie vorteilhafterweise derart dimensioniert, dass ein kontrollierbares Abbrennen der ersten Deckschicht erfolgt.

## Patentansprüche

1. Formteil (2), umfassend
- ein transparentes Material,
- eine Deckschicht (4),
**dadurch gekennzeichnet, dass** zwischen der Deckschicht (4) und dem transparenten Material eine
- Grundschicht (5) mit einer
i. ersten Oberfläche (5a) und
ii. einer zweiten Oberfläche (5b) derart angeordnet ist,
dass die erste Oberfläche (5a) zu der Deckschicht (4) gerichtet ist und die zweite Oberfläche (5b) zu dem transparenten Material gerichtet ist, wobei die Grundschicht (5) geeignet ist einen in das transparente Material eingeleiteten Lichtstrahl bis an die erste Oberfläche (5a) der Grundschicht (5) zu führen.

2. Formteil (2) nach Annspruch 1, ausgestaltet als eine Geräteabdeckung (1) .

3. Formteil (2) nach Anspruch 1 oder 2, wobei die Grundschicht (4) als eine Lackschicht oder eine Folie ausgestaltet ist.

4. Formteil (2) nach einem der Ansprüche 1 bis 3, welches im Wesentlichen gänzlich aus dem transparenten Material gefertigt ist.

5. Formteil (2) nach einem der Ansprüche 1 bis 4, aufweisend Anformungen oder Stege, welche als Lichtleiter (11a,12a) ausgestaltet sind.

6. Formteil (2) nach einem der Ansprüche 1 bis 5, wobei die Deckschicht (4) Ausnehmungen aufweist, welche Anzeigebereiche und/oder Schriftzeichen bilden, wobei die Ausnehmungen die erste Oberfläche (5a) der Grundschicht (5) derart stellenweise freilegen, das der eingeleitete Lichtstrahl an der ersten Oberfläche (5a) austreten kann.

7. Formteil (2) nach einem der Ansprüche 1 bis 6, wobei die Deckschicht (4) ein weitestgehend lichtundurchlässiges Material und die Grundschicht (5) ein weitestgehend lichtdurchlässiges, insbesondere transluzentes, Material ist.

8. Formteil (2) nach einem der Ansprüche 1 bis 7, wobei die Deckschicht (4) eine Laser- und thermisch beschreibbare Oberfläche aufweist.

9. Verfahren zum Herstellen von Formteilen (2), wobei diese aus einem transparenten Material geformt werden,
- auf das transparente Material eine Grundschicht (5) mit einer
i. ersten Oberfläche (5a) und
ii. einer zweiten Oberfläche (5b)
derart aufgetragen wird, dass die zweite Oberfläche (5b) zu dem transparenten Material gerichtet ist,
wobei für die Grundschicht (5) ein Material verwendet wird, welches geeignet ist, einen in das transparente Material eingeleiteten Lichtstrahl bis an die erste Oberfläche (5a) der Grundschicht (5) zu führen,
- auf die Grundschicht (5) eine Deckschicht (4) aufgetragen wird.

10. Verfahren nach Anspruch 9, wobei beim Formen des Materials Anformungen oder Stege gebildet werden, welche als Lichtleiter (11a,12a) ausgestaltet sind.

11. Verfahren nach Anspruch 9 oder 10, wobei in die Deckschicht (4) Ausnehmungen eingebracht werden, welche Anzeigebereiche und/oder Schriftzeichen bilden, wobei die Ausnehmungen die erste Oberfläche (5a) der Grundschicht (5) derart stellenweise freilegen, das der eingeleitete Lichtstrahl an der ersten Oberfläche (5a) austreten kann.

12. Verfahren nach Anspruch 11, wobei die Ausnehmungen durch stellenweises Entfernen der Deckschicht (4) mittels eines Lasers eingebracht werden.

13. Verfahren nach Anspruch 11 oder 12, wobei für die Deckschicht (4) ein Stoff mit lasermarkierbaren Pigmenten verwendet wird.
